# EUROPEAN PATENT SPECIFICATION

(11) **EP 1 928 221 B1**
(45) Date of publication and mention of the grant of the patent: **04.05.2011**
(21) Application number: 07020356.7
(22) Date of filing: 18.10.2007
(51) Int. Cl.: H05K 13/00

(54) **Accumulator device for electronic components**
Akkumulatorvorrichtung für elektronische Bauteile
Dispositif accumulateur pour composants électroniques

(30) Priority: 29.11.2006 IT MI20062296
(43) Date of publication of application: 04.06.2008
(73) Proprietor: ESSEGI SYSTEM SERVICE S.r.l., 36050 Sovizzo (VI) (IT)
(72) Inventor: Zerbato, Giuliano, 36033 Isola Vicentina (Vicenza) (IT)
(74) Representative: Lecce, Giovanni

(56) References cited:
- EP-A1- 0 302 542
- JP-A- 2005 347 352
- US-A- 5 456 001
- US-A1- 2003 000 959

## Description

The present invention relates to an accumulator device for electronic components.

More in particular, the present invention relates to an accumulator device especially suitable for being used in automatic or semi-automatic stores for storing electronic components, in particular reels or rolls of SMD (Surface Montage Devices) components.

As known, the electronic components and in particular, SMD components, intended to be mounted on electronic boards in order to carry out precise functions, are wound in tapes or reels which are placed in stores or cabinets suitable for storage.

The single reels of SMD components, stored in said stores, are identified by a special code, for example of the bar type, which contains all the information relating to the type of electronic components contained in the single reels and the information relating to the location of the same reels into the store.

The reels of SMD components are managed in such stores according to manual, semi-automatic or automatic logics.

In the case of a manual store, when the operator needs electronic components suitable for making an electronic board, he/she looks for the reel(s) into the store itself by the identification code and manually carries out the pick up and the subsequent replacement of the reels into the store in the positions marked by the code.

In the case of a semi-automatic or automatic store, the operator selects the reels he/she needs by the code and the system presents them one by one to the same operator. The pick up and the replacement of the single reels, in the case of a fully automatic store, can take place for example by a mechanical actuator that pick up/replaces the reel from its containment cell or seat.

However these devices exhibit considerable drawbacks related to the fact that the operator must select the electronic components he/she needs for the production and then the reel that contains them into the store; moreover, such reels are presented to the operator one at a time. Likewise, as already mentioned hereinbefore, during the step of replacement of the reels in the store, the operator must provide for the reintroduction of every single reel in a predetermined zone of the store or, in the case of an automatic store, he/she places the single reel on a plate or tray and a special actuator provides for the replacement of the same. It is therefore deduced that the operations for looking for the reels and for their subsequent replacement in the store are very costly for the operator in terms of time.

A further drawback is represented by the fact that in carrying out such operations the operator must be very careful and precise, since he/she has to control the pick up of the reels from the store and their subsequent correct replacement in the positions they had been picked up from; the operation for removing and above all for replacing the reels into the store may entail errors by the operator.

An accumulator device according to the prior art portion of claim 1 is known from US-A-5456001.

The object of the present invention is to obviate the drawbacks discussed hereinabove.

More in particular, the object of the present invention is to provide an accumulator device for electronic components which should allow picking up from the store and replace into the same multiple reels at the same time.

A further object of the present invention is to provide a device suitable for reducing the times, traditionally long, for picking up and replacing the reels into the store and to prevent any errors by the operator.

A further object of the present invention is to provide the users with the accumulator device for electronic components of the present invention suitable for ensuring a high level of resistance and reliability over time, also such as to be easily and inexpensively constructed.

These and other objects are achieved by the accumulator device for electronic components of the present invention as defined in claim 1.

The construction and functional features of the accumulator device for electronic components of the present invention can be better understood from the following detailed description, wherein reference is made to the annexed drawings showing a preferred and non-limiting embodiment thereof, and wherein:
figure 1 shows a top schematic front view of the accumulator device for electronic components of the invention;
figure 2 shows a front dissected schematic view of the device of the invention;
figure 3 shows a schematic axonometric view of the device of the invention;
figure 4 shows an axonometric schematic view of a longitudinal section of the device of the invention;
figure 5 shows a schematic view of the device of the invention integrated in a store for storing electronic components.

With reference to the above figures, the accumulator device for electronic components of the present invention, globally indicated with 10 at the figures, comprises a container body 12 of substantially parallelepiped shape and closed on five out of the six faces for substantially forming a "box"; said container body 12 is made of a metal or other suitable type of material and is obtained, for example, through a moulding operation by drawing, bending-welding or other known type.

Expansions or lips 14 and 14' are defined along each of the edges of the open front side or face of the container body 12, preferably extending by the entire length of the corresponding edges and exhibiting a plurality of holes or slots 15 the function whereof shall be explained hereinafter; in an alternative embodiment such expansions or lips 14 and 14' may be formed on the corresponding edges in a discontinuous manner.

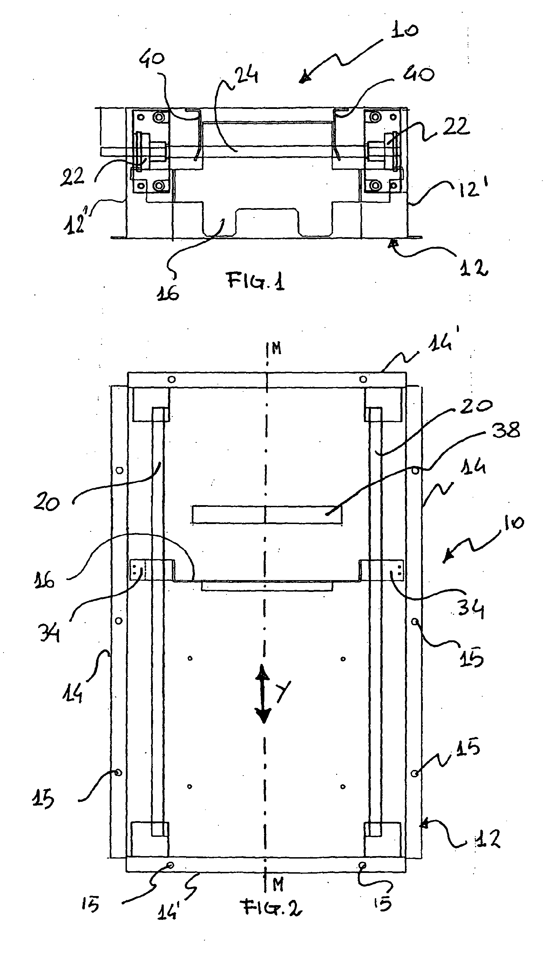

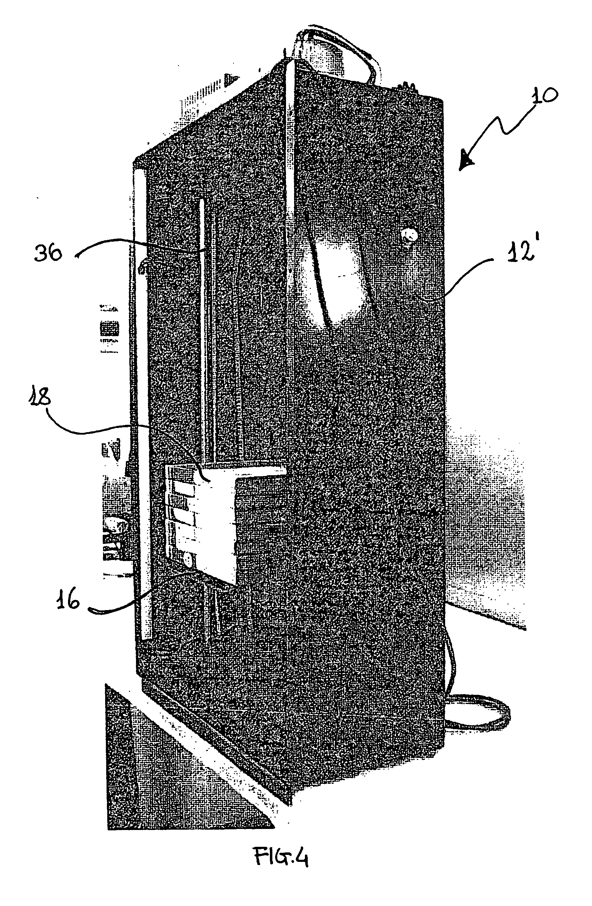

A shaped plate or tray 16 is arranged inside the container body 12, suitable for receiving one or more reels 18 of electronic components picked up from the store, as schematised at figures 1, 2 and 4. Said plate or tray 16, which is made of metal sheet or other suitable material, is arranged according to a direction substantially parallel to the support surface of the store and can slide according to the vertical direction indicated with the arrow Y in figure 2.

The sliding of the tray 16 is actuated by at least two belts 20 and, preferably of the toothed type, arranged inside or outside the container body 12, nearby and parallel to the inner surface of the side faces 12'.

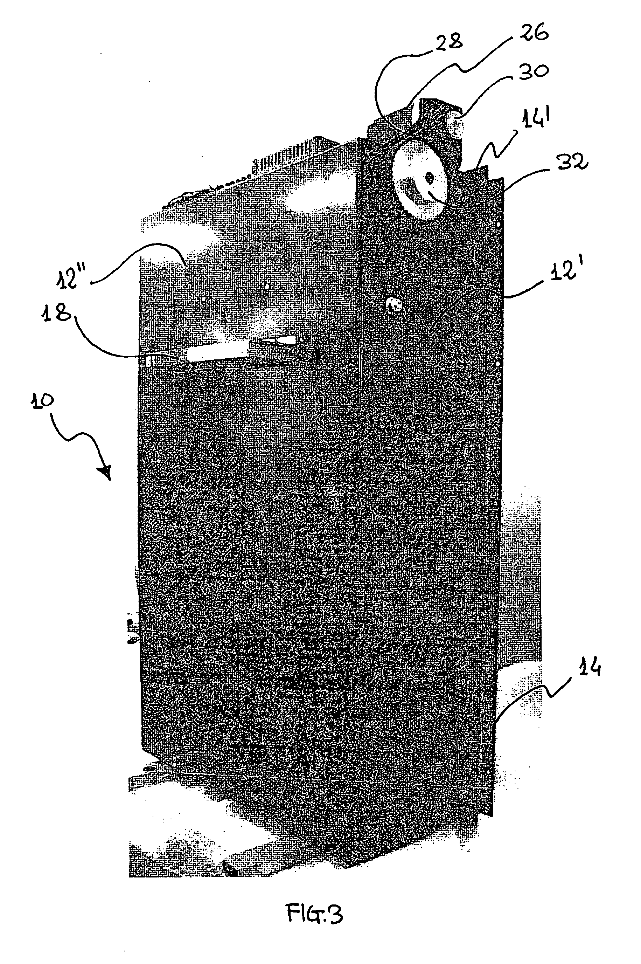

Said belts are each wound on at least two toothed wheels or pinions 22 connected by a shaft 24 and placed in rotation by a conventional motor 26, of the stepping or torque type or other known type, arranged outside or inside the container body as schematised in figure 3.

The motion transmission from the motor 26 to the toothed wheels or pinions 22 takes place, in the preferred embodiment at the figures, in a traditional manner using a belt-pinion system defined by a further belt 28 wound on a first further pinion 30 and on a second further pinion 32; both the further belt 28 and the first further pinion 30 and the second further pinion 32 are arranged outside the container body 12, with the second further pinion 32 fixed coaxially to the shaft 24 of connection between the toothed wheels or pinions 22.

Two or more opposite plates 34 are formed or applied along the side edges of the tray 16 fixed to the belts 20 and the ends whereof are slidingly arranged relative to at least two vertical guides 36, fixed to the inner surface of the side faces 12' of the container body 12. Said guides 36 have the function of allowing the correct sliding of the tray 16 along the direction Y.

In an alternative embodiment the motor 26 may be fixed directly to the shaft 24 that places in rotation the toothed wheels or pinions 22.

In a further alternative embodiment the movement of the tray 16 according to the direction Y can be actuated using a device of the pinion-rack type, worm screw or electrical actuators.

The back side or face 12" opposite the open front side or face of the container body 12 exhibits, basically at the centre-top end of the back front 12" itself and centred relative to the greater median line M-M of the container body 12, an opening or slit 38 the horizontal dimension whereof and the height whereof are such as to allow the passage of a reel 18 of electronic components according to the ways described hereinafter.

Two shoulders 40, shaped and made of metal or other suitable material, are arranged on the same back side or face 12" of the container body 12, at the opening 38 and adjacent the smaller sides of the same, suitable for defining a guide for the reels 18 according to the ways that shall be detailed hereinafter; said shoulders 40 are fixed to the back front 12" of the container body 12 in a known manner, for example by screws, gluing or the like.

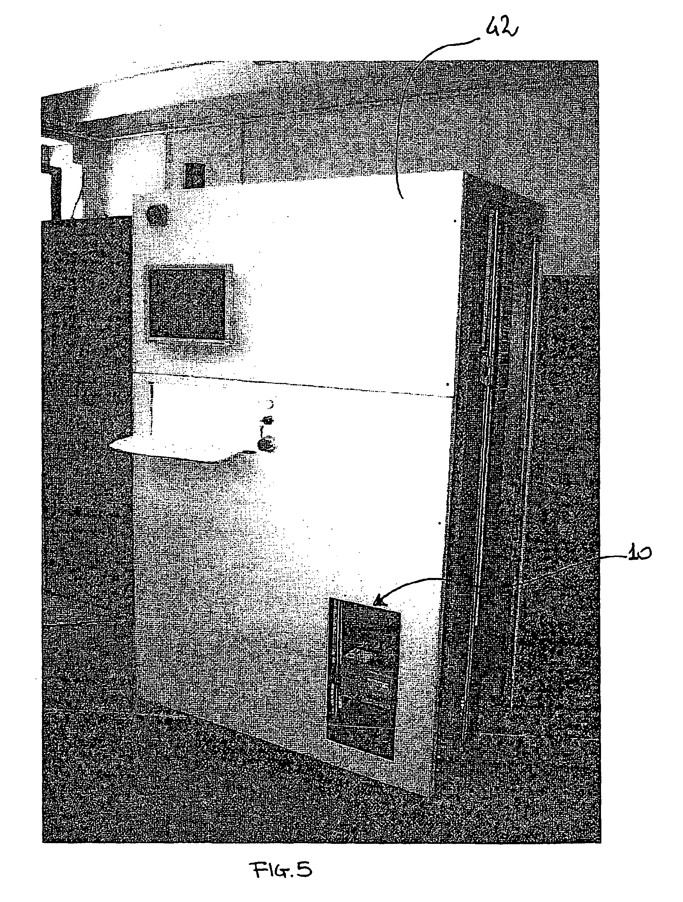

With particular reference to figure 5, the device 10 of the invention is arranged with the expansions or lips 14 and 14' of the open face of the container body 12 in contact with the inner surface of the store 42 of reels 18 of electronic components and nearby its bottom zone thereof; said device 10 is fixed to the store 42 in a known manner, for example by screws or other known types of retaining means. Moreover, the open face of the container body 12 of the device of the invention is in case closed by a door (not shown in the figure).

In an alternative embodiment, such device 10 of the invention is fixed on the outside of the store 42. Moreover, the fixing position of such device relative to the store 42, either internal or external, may be at any height.

Moreover, a software program is associated the device 10 of the invention which has the function of controlling and managing the operation of the device itself and at the same time that of the store 42.

The accumulator device of the invention described in detail hereinabove as regards its structural components, is described hereinafter with reference to the operating mode.

When the operator needs to have electronic components for making a board, he/she enters the code of the reel(s) 18 to be picked up by the specific software. A mechanical hand or actuator, inside the store 42 and preferably of the pick & place type, receives the command via software and moves towards the cell of the store containing the reel matching the selected code, identifies it through a code reader (for example on the reels there are bar codes that contain all the information relating to the reel), picks it up from the cell and places it on the tray 16 of the accumulator device 10 introducing it through the slit or opening 38. Once the tray 16 has received a reel, it lowers by a quantity equal to the height of the reel itself and is thus ready for receiving a subsequent reel; for every new reel received the tray 16 lowers by a quantity equal to the height of the reel itself and this lowering continues until all the reels requested by the operator have been arranged on the tray. The accumulator device is provided with a conventional position sensor, for example a photocell, which detects the condition of reel placed on the tray 16 and enables the mechanical hand to pick up another reel.

Once all the requested reels have been loaded on the tray 16, this lowers further and presents them to the operator for the pick up.

Likewise, when the operator has completed the use of the electronic components, he/she places the reels on the tray 16 which moves to the height of the slit 38 to allow the gripper of the mechanical hand of the store 42 to pick up the reel and place it in the cell of the store matching its code. As in the step of loading onto the tray, in unloading too, for each reel picked up by the hand the tray 16 raises by a quantity equal to the height of the reel so as to move the next reel at the height of the slit 38 and allow the pick up thereof by the hand. This operation continues until all the reels on the tray 16 have been picked up from the tray and replaced into the store cells.

As can be noticed from the above, the advantages achieved by the invention are clear.

The accumulator device for electronic components of the present invention advantageously allows to provide the operator with multiple reels of electronic components at the same time.

A further advantage is the fact that since the device of the invention allows the operator not to have to pick up and replace one reel at a time on the accumulator, it allows drastically reducing the time for picking up and replacing the reels into the store and moreover it allows the operator to carry out other operations in "masked" time, that is, while the reel loading/unloading operation is in progress; moreover, this allows reducing the production times.

A further advantage of the device of the invention is represented by the fact that during the step of replacement of the reels into the store, the operator can place multiple reels on the tray and even according to an order other than that by which they had been picked up from the store; a code reader will provide for the identification of the reel position in the suitable store cell and will send the information to the control system suitable for allowing the movement of the mechanical hand at said cell. Moreover, this allows reducing the mistakes that may be made by the operator.

Even if the invention has been described hereinbefore with particular reference to an embodiment thereof made by way of a non-limiting example only, several changes and variations will appear clear to a man skilled in the art in the light of the above description. The present invention therefore is intended to include any changes and variations thereof falling within the scope of the following claims.

## Claims

1. An accumulator device (10) for reels of electronic components, especially suitable for being used in automatic or semi-automatic stores for storing electronic components, in particular reels or rolls of SMD (Surface Montage Devices) components which comprises:
- a container body (12) of substantially parallelepiped shape;
- a shaped plate or tray (16), arranged inside said container body (12) and suitable for receiving one or more of said reels (18) of electronic components picked up from a store (42) associated with said container body (12);
- means for controlled movement along a vertical axis of said tray (16) inside said container body and suitable for allowing the loading and the unloading of one or more reels of electronic components onto said tray;
said accumulator device being **characterised in that**
- said container body (12) is closed on five out of the six sides and exhibits a back side (12") opposite the open front side of said container body (12) which defines, at its centre-top end and centred relative to the greater median line of said container body (12), an opening (38) suitable for allowing the passage of a reel (18), and **in that**
it comprises means for lowering said tray (16) by an amount equal to the height of the loaded reel whereby a subsequent reel is loaded stacked over the preceding one, and for raising said tray (16) by an amount equal to the height of an uploaded reel so as to move the next stacked reel to the height of said opening (38).

2. The accumulator device according to claim 1, **characterised in that** said control means of the tray vertical motion comprises two or more belts (20) each wound on at least two toothed wheels or pinions (22), connected by a shaft (24) and placed in rotation by a motor (26), and at least two guides (36) suitable for allowing a correct and precise sliding relative to the vertical axis (Y).

3. The accumulator device according to claim 2, **characterised in that** said belt(s) (20) are of the toothed type, arranged inside the container body (12) nearby and parallel to the inner surface of the side faces (12') of the container body itself.

4. The accumulator device according to claim 2 or 3, **characterised in that** said motor (26) is a stepping motor.

5. The accumulator device according to claim 2 or 3, **characterised in that** said motor (26) is a torque motor.

6. The accumulator device according to claim 2, **characterised in that** the motion transmission from said motor (26) to said toothed wheels or pinions (22) uses a belt-pinion system comprising a further belt (28) wound on a first additional pinion (30) and on a second additional pinion (32), this latter being coaxially fixed to said shaft (24).

7. The accumulator device according to claim 6, **characterised in that** said motor (26) is directly fixed to the shaft (24) that drives said toothed wheels or pinions (22).

8. The accumulator device according to any of claims 1 to 7, **characterised in that** the movement of said tray (16) according to the direction (Y) is accomplished through a pinion-rack type device.

9. The accumulator device according to any of claims 1 to 7, **characterised in that** the movement of said tray (16) according to the direction (Y) is actuated by a screw.

10. The accumulator device according to any of claims 1 to 7, **characterised in that** the movement of the tray (16) according to the direction (Y) is realised using one or more electrical actuators.

11. The accumulator device according to claim 2, **characterised in that** two or more opposite plates (34) are formed along the side edges of said tray (16) fixed to said belt(s) (20), and the ends of said plates (34) are slidingly arranged relative to the at least two guides (36) fixed to the inner surface of the side faces (12') of the container body (12).

12. The accumulator device according to of the preceding claims, **characterised in that** two shoulders (40) shaped and suitable for defining a guide for the reels (18) are arranged at said opening (38) and adjacent the smaller sides of this latter.

13. The accumulator device according to any of the preceding claims, **characterised in that** the open side of said container body (12) is closed by a door.

14. The accumulator device according to any of claims 1 to 13, **characterised in that** it is fixed inside said store (42).

15. The accumulator device according to any of claims 1 to 13, **characterised in that** it is fixed outside said store (42).

## Patentansprüche

1. Ein Speichergerät (10), für Rollen elektronischer Bauelementen, besonders geeignet zur Verwendung in automatischen oder halbautomatischen Lagern für die Speicherung von elektronischen Bauteilen, insbesondere Spulen oder Rollen von SMD-Komponenten (Surface Montage Devices), bestehend aus:
- Einem Behältergehäuse (12), mit grundsätzlich quaderförmiger Form;
- Eine geformte Platte oder Tablett (16), angeordnet innerhalb des genannten Behältergehäuses (12) und geeignet zur Aufnahme einer oder mehrerer der genannten Spulen (18) mit elektronischen Bauteilen, aus einem Lager (42) verbunden mit dem genannten Behältergehäuse (12);
- Mittel zur kontrollierten Bewegung entlang einer vertikalen Achse des Tabletts (16) innerhalb des Behältergehäuses und geeignet für die Be- und Entladung von einer oder mehreren Spulen der elektronischen Bauteile auf das Tablett;
Die genannte Speichervorrichtung zeichnet sich dadurch aus, dass
- genanntes Behältergehäuse (12)/(15) auf fünf der sechs Seiten geschlossen ist und eine Rückseite (12") gegenüber der offenen Vorderseite des Behältergehäuses (12) aufweist, welche am oberen mittleren Ende und zentriert auf die größere Mittellinie des genannten Behältergehäuses (12) eine Öffnung (38) für den Übergang einer Spule (18) definiert, und dass
es Mittel für die Absenkung des Tabletts (16) um einen gleichlautenden Wert zur Höhe des geladenen Spule, wobei eine spätere Spule auf die vorhergehende gestapelt wird, und für die Anhebung des Tabletts (16) um einen gleichlautenden Wert zur Höhe einer geladenen Spule umfasst, so dass die nächste gestapelte Spule auf die Höhe der genannten Öffnung (38) bewegt wird.

2. Das Speichergerät gemäß Anspruch 1, **dadurch gekennzeichnet, dass** die genannten Steuerungen der vertikalen Tablettbewegung aus zwei oder mehr Riemen (20) bestehen, jeweils auf mindestens zwei Zahnräder oder Ritzel (22) gewickelt, durch eine Welle (24) verbunden und durch einen Motor (26) in Drehung versetzt und mindestens zwei Führungen (36), die sich für eine korrekte und präzise Verschiebung gegenüber der vertikalen Achse (Y) eignen.

3. Das Speichergerät gemäß Anspruch 2, **dadurch gekennzeichnet, dass** genannte(r) Riemen (20) verzahnt ist/sind, im Inneren des Behälterkörpers (12), in der Nähe und parallel zu den inneren Oberflächen der Seitenflächen (12') des Behälterkörpers angeordnet.

4. Das Speichergerät gemäß Anspruch 2 oder 3, **dadurch gekennzeichnet, dass** der Motor (26) ein Schrittmotor ist.

5. Das Speichergerät gemäß Anspruch 2 oder 3, **dadurch gekennzeichnet, dass** der Motor (26) ein Regelmotor ist.

6. Das Speichergerät gemäß Anspruch 2, **dadurch gekennzeichnet, dass** die Bewegungsübertragung vom Motor (26) auf die Zahnräder oder Ritzel (22) ein Riemen-Ritzel-System mit einem weiteren Band (28) verwendet, aufgewickelt auf ein erstes zusätzliches Ritzel (30) und ein zweites zusätzliches Ritzel (32), wobei letzteres koaxial fest mit der Welle (24) verbunden ist.

7. Das Speichergerät gemäß Anspruch 6, **dadurch gekennzeichnet, dass** der genannte Motor (26) direkt mit der Welle (24) verbunden ist, die die genannten Zahnräder oder Ritzel (22) antreibt.

8. Das Speichergerät gemäß einem der Ansprüche 1 bis 7, **dadurch gekennzeichnet, dass** die Bewegung des Tabletts (16) entsprechend der Richtung (Y) durch eine Ritzel-Zahnstangen-Vorrichtung erfolgt.

9. Das Speichergerät gemäß einem der Ansprüche 1 bis 7, **dadurch gekennzeichnet, dass** die Bewegung des Tabletts (16) entsprechend der Richtung (Y) durch eine Spindel erfolgt.

10. Das Speichergerät gemäß einem der Ansprüche 1 bis 7, **dadurch gekennzeichnet, dass** die Bewegung des Tabletts (16) entsprechend der Richtung (Y) durch einen oder mehrere elektrische Stellantriebe erfolgt.

11. Das Speichergerät gemäß Anspruch 2, **dadurch gekennzeichnet, dass** zwei oder mehr gegenüberliegenden Platten (34) entlang der Seitenkanten des genannten Tabletts (16) ausgebildet sind, fest mit dem/den genannten Band/Bändern (20) verbunden und die Enden der genannten Platten (34) sind mit mindestens zwei Führungen (36) an der inneren Oberfläche der Seitenflächen (12') des Behältergehäuses (12) gleitend angeordnet.

12. Das Speichergerät gemäß einem der vorhergehenden Ansprüche, **dadurch gekennzeichnet, dass** zwei Schultern (40), geformt und geeignet für die Definition einer Führung der Spulen (18) bei der Öffnung (38) und neben der Schmalseiten der letzteren angeordnet sind.

13. Das Speichergerät gemäß einem der vorhergehenden Ansprüche, **dadurch gekennzeichnet, dass** die offene Seite des genannten Gehäusekörpers (12) durch eine Tür geschlossen wird.

14. Das Speichergerät gemäß einem der Ansprüche 1 bis 13, **dadurch gekennzeichnet, dass** es innerhalb des genannten Lagers (42) befestigt ist.

15. Das Speichergerät gemäß einem der Ansprüche 1 bis 13, **dadurch gekennzeichnet, dass** es außerhalb des genannten Lagers (42) befestigt ist.

## Revendications

1. Un dispositif accumulateur (10) pour des bobines de composants électroniques, particulièrement adapté pour être utilisé dans des magasins automatiques ou semi-automatiques pour stocker des composants électroniques, en particulier des bobines ou des rouleaux de composants CMS (Composants montés en surface) lequel comprend :
- un conteneur (12) substantiellement en forme de parallélépipède ;
- une plaque profilée ou un plateau (16), positionné à l'intérieur dudit corps conteneur (12) et capable de recevoir une ou plusieurs desdites bobines (18) de composants électroniques prélevées d'un magasin (42) associé audit corps container (12) ;
- des dispositifs pour des mouvements contrôlés dudit plateau (16) le long d'un axe vertical à l'intérieur du corps conteneur et permettant le chargement et déchargement d'une ou plusieurs bobines de composants électroniques dans ledit plateau ;
ledit dispositif accumulateur **se caractérisant par le fait que**
- ledit corps conteneur (12) / (15) est fermé sur cinq des six côtés et présente la partie arrière (12") à l'opposé de la partie frontale ouverte dudit corps du container (12) laquelle délimite à son extrémité centrale supérieure et centrée par rapport à l'axe médian majeur dudit corps container (12), une ouverture (38) apte à permettre le passage d'une bobine (18), et **par le fait que**
il comprend des dispositifs pour baisser ledit plateau (16) d'une course égale à l'hauteur de la bobine chargée lorsque une ultérieure bobine est chargée empilée sur la précédente, et pour soulever ledit plateau (16) d'une course égale à l'hauteur de la bobine chargée de la sorte à positionner la bobine empilée suivante à hauteur de ladite ouverture (38).

2. Le dispositif accumulateur conformément à la revendication 1, se **caractérise par le fait que** ledit dispositif de contrôle du mouvement vertical du plateau se compose de deux ou plus courroies (20) chacune enroulée sur au moins deux roues crantées ou pignons (22), reliés par un arbre (24) et mis en rotation par un moteur (26), et par au moins deux guides (36) qui permettent un glissement correct et précis par rapport à l'axe vertical (Y).

3. Le dispositif accumulateur conformément à la revendication 2, se **caractérise par le fait que** lesdites corroies (20) sont crantées, positionnées à l'intérieur du corps du container (12) à proximité et parallèles à la surface intérieure des faces latérales (12') du corps conteneur même.

4. Le dispositif accumulateur conformément à la revendication 2 ou 3, **se caractérisant par le fait que** ledit moteur (26) est un moteur pas à pas.

5. Le dispositif accumulateur conformément à les revendications 2 ou 3, **se caractérisant par le fait que** ledit moteur (26) est un moteur couple.

6. Le dispositif accumulateur conformément à la revendication 2, **se caractérisant par le fait que** la transmission du mouvement à partir de ce moteur (26) auxdites roues crantées ou pignons (22) utilise un système corroie-pignon qui inclue par la suite une corroie (28) enroulée sur un premier pignon additionnel (30) et un deuxième pignon additionnel (32), ce dernier étant fixé coaxial audit arbre (24).

7. Le dispositif accumulateur conformément à la revendication 6, **se caractérisant par le fait que** ledit moteur (26) est directement relié à l'arbre (24) qui actionne lesdits roues crantées et pignons de transmission (22).

8. Le dispositif accumulateur conformément à chacune des revendications de 1 à 7, **se caractérisant par le fait que** le mouvement dudit plateau (16) selon la direction (Y) est commandé par un dispositif de type pignon-crémaillère.

9. Le dispositif accumulateur conformément à chacune des revendications de 1 à 7, **se caractérisant par le fait que** le mouvement dudit plateau (16) selon la direction (Y) est commandé par une vis.

10. Le dispositif accumulateur conformément à chacune des revendications de 1 à 7, **se caractérisant par le fait que** le mouvement dudit plateau (16) selon la direction (Y) est obtenu en utilisant un ou plusieurs actuateurs électriques.

11. Le dispositif accumulateur conformément à la revendication 2, **se caractérisant par le fait que** deux ou plus plaques opposées (34) sont constitués le long des bords latéraux dudit plateau 6) fixé à ladite / auxdites corroie(s) (20), et que les extrémités desdites plaques (34) sont conçues de manière à pouvoir les faire glisser par rapport à deux ou plus guides (36) fixés sur la surface interne des faces latérales (12') du corps du conteneur (12).

12. Le dispositif accumulateur conformément aux précédentes revendications, **caractérisé par le fait que** deux épaulements (40) profilées et aptes à former un guide pour les bobines (18) sont disposées à proximité de ladite ouverture (38) et adjacentes aux côtés plus court de cette dernière.

13. Le dispositif accumulateur conformément à chacune des précédentes revendications, **caractérisé par le fait que** le côté ouvert dudit corps conteneur (12) est fermé par une porte.

14. Le dispositif accumulateur conformément à chacune des précédentes revendications de 1 à 13, **se caractérisant par le fait qu'**il est fixé à l'intérieur dudit magasin (42).

15. Le dispositif accumulateur conformément à chacune des précédentes revendications de 1 à 13, **se caractérisant par le fait qu'**il est fixé à l'extérieur dudit magasin (42).
